Europäisches Patentamt

European Patent Office

Office européen des brevets

(11) Publication number: **0 122 058**
**A2**

(12) **EUROPEAN PATENT APPLICATION**

(21) Application number: **84301675.9**

(22) Date of filing: **13.03.84**

(51) Int. Cl.³: **H 01 R 43/00**

(30) Priority: **16.03.83 US 475778**

(43) Date of publication of application: **17.10.84**
**Bulletin 84/42**

(84) Designated Contracting States: **DE FR GB IT NL SE**

(71) Applicant: **TEXAS INSTRUMENTS INCORPORATED,**
**13500 North Central Expressway, Dallas**
**Texas 75265 (US)**

(72) Inventor: **Evans, Thomas E., Fairlaine RFD 3, Rehoboth**
**Massachusetts 02769 (US)**

(74) Representative: **Abbott, David John et al, Abel & Imray**
**Northumberland House 303-306 High Holborn, London,**
**WC1V 7LH (GB)**

(54) Method and apparatus for assembling electrical contact elements in an electrically insulative body.

㋷ Electrical sockets used for mounting integrated circuits and the like are assembled by sequentially feeding electrically insulative bodies onto a track between a pair of endless belts which transmit motion to the bodies forcing them to move along a first path which extends beyond the belts. The socket bodies typically are provided with two parallel rows of contact receiving apertures which extend through the bodies from the top surface to the bottom surface thereof. A continuous carrier strip having spaced contact elements depending therefrom is directed along a second path which tangentially meets the first path so that the contact elements are sequentially received in one of the two rows of contact receiving apertures. The contact elements are securely seated by means of a seating roller and are then staked in position by one or more staking rollers after which the contact elements are severed from the carrier strip. Another carrier strip having similar spaced contact elements depending therefrom is directed along a third path which tenagentially meets the first path so that the contact elements are sequentially received in the other of the two rows of contact receiving apertures. The contact elements of the other row are then in turn seated, staked and severed from the carrier strip in the same manner as in the one row. The assembled sockets are then placed in suitable storing or shipping containers for ultimate use.

ACTORUM AG

METHOD AND APPARATUS FOR ASSEMBLING ELECTRICAL
CONTACT ELEMENTS IN AN ELECTRICALLY INSULATIVE BODY

Background of the Invention

This invention relates generally to electrical
sockets for mounting integrated circuits and the like and
more particularly to a method and apparatus for assembling
such sockets.

Such sockets generally comprise a body of electrically
insulative material having a plurality of contact receiving
apertures extending from a top surface down to a bottom
surface of the body.  A common type of socket has a pair of
rows of contact receiving apertures.  Depending upon the
application for which the socket is to be used, a variety
of contact configurations have become common with regard to
the spacing between the rows as well as the total number of
contacts in a row.  One of the most common is a sixteen
position or contact socket having two rows of eight contacts
with the socket being slightly less than an inch in length.
On the other hand, sockets could have many more contact
positions and be several inches long.  Although there are
many socket variations, it is accepted industry standard to
space the contacts in a row the same distance from one
another.

- 2 -

0122058

## Description of the Prior Art

A conventional way of assembling such sockets involves the use of a machine having a turntable with dial indexing of a number of fixture stations. The machine is adapted to accommodate at each position as many socket bodies, one behind another, as will total a selected total length, for example three inches. In such a machine one could load three sixteen position bodies of the type described above since each is slightly less than one inch in length, or alternatively only one body if it is over an inch and a half in length. Sections of contact elements, attached to a selvedge or carrier web are fed into an appropriate holder, lined up with the bodies and inserted into one row of apertures. Sections of contacts are fed into another holder for insertion into the other row of apertures. The contacts of each row are severed from the carrier strip, the sockets are coded and ejected from the machine. For each of the above operations the turntable is indexed around from one work station to another. By way of example, one such machine has a total of eight work stations. Using this type of apparatus to assembly sockets involves several undesirable, inherent limitations regarding efficiency, reliability and speed of assembly. For example, for each type of socket the set up must be varied. A change in the width of the body requires a change in alignment for feeding of at least one of the contact sections. A change in the length of the sockets, e. g. two thirty position sockets rather than three eighteen position sockets, requires a different length of contact carrier section. Once the apparatus is set up there is still significant lost time, including the time for indexing the stations which consume in the order of a third to a half of one complete cycle. There is a finite period of time required for tooling to approach and move away from a work station.

- 3 -

0122058

## Summary of the Invention

It is an object of the invention to provide an improved method and apparatus for assembling contacts into a body, one which is faster than prior art approaches yet is economical and reliable. Another object is the provision of a method and apparatus for assembling electrical sockets which can be used with different socket body widths and lengths without requiring set up times when changing from one body size to another. Yet another object is the provision of apparatus for assembling sockets which independent of the number of contact positions in a body as well as the width of the body. Other objects and features will be in part apparent and in part pointed out herein after.

Briefly, in accordance with the invention, an electrically insulative body having a pair of row of contact receiving apertures extending along the length of the body are placed sequentially onto a track along a first path between opposed, endless belts which are firmly biased against opposed sides of the body. The belts impart motion to the bodies moving them through direct frictional engagement along a selected length of the first path after which the bodies are moved by the pushing force of upstream bodies. One side of the body is referenced by camming the body over to one side of the track and a continuous carrier strip having spaced contact elements depending therefrom is directed along a second path which tangentially meets the first path with the contact elements sequentially being received in the contact receiving apertures of the row closest to the referenced side of the body. Once received in the bodies, the contact elements, through the carrier strip, transfer motion from the bodies to the carrier strip, in effect pulling the carrier strip from a reel as required. Complete seating of the contacts is ensured by engaging a seating surface with the contact elements as the body moves past the surface. The contact elements are then staked to the body by deforming selected portions of the body with a deforming surface onto the contact elements as the body moves past the deforming surface. The body, still moved by the pushing force of upstream bodies, passes by a severing station at which a pair of counter-rotating wheels mounted on axes which lie in a plane perpendicular to the longitudinal axis of the first path at the severing station sever the contact elements from the carrier strip. The plane in which the wheels rotate is preferably inclined relative to plane in which the contact elements move.

The bodies, now free of the carrier strip and still being pushed by upstream bodies, are referenced so that the other side of the bodies are moved to the other side of the track by a camming surface. Another continuous carrier strip having spaced contact elements depending therefrom is directed along a third path which tangentially meets the first path with the contact elements sequentially being received in the contact receiving apertures of the row closest to the newly referenced side of the body (the other row). As in the case of the first row, the contact elements of the other row are then in turn seated, staked and severed from the carrier strip. The assembled sockets are then placed in suitable storing or shipping means for future handling.

Brief Description of the Drawings

The above summary will become more clear from a detailed description in connection with the accompanying drawings wherein:

Fig. 1 is a plan view of a suitable electrical socket body into which electrical contacts can be assembled in accordance with the invention.

Fig. 2 is a cross section of the socket body of Fig. 1 showing a contact receiving aperture in each of two rows with a contact element received in each aperture.

Fig. 3 is a schematic diagram showing apparatus for assembling contact elements into socket bodies in accordance with the invention.

Fig. 4 is an enlarged top plan view, partly broken away, of the socket feeding means.

Fig. 5 is a front elevational view of the Fig. 4 feeding means.

Fig. 6 is an end view of the Figs. 4, 5 feeding means.

Fig. 7 is a partial end view of a guide rail support.

Fig. 8 is a cross sectional view of the feeding means showing details of idler air spring means.

Fig. 9 is a front elevational view of the socket track comprising a portion of the first path and contact strip guide means comprising a portion of the second path.

Fig. 10 is an enlarged, perspective view of a portion of the guide means of the contact strip.

Fig. 11 is an enlarged front elevational view of a portion of the contact carrier strip with two contact elements depending therefrom.

Fig. 12 is a top plan view of a seating and staking roll assembly.

Fig. 13 is a front elevational view of the Fig. 12 assembly.

Fig. 14 is an enlarged cross sectional view of a portion of the seating roller engaging a contact element in the first row.

- 6 -

0122058

Fig. 15 is a cross sectional view showing an end view of a staking roller.

Fig. 16 is an enlarged cross sectional view of a portion of Fig. 15 showing the staking roll deforming a portion of the socket body onto a contact element.

Fig. 17 is a cross sectional view showing an end view of the severing wheels for the first row of contacts.

Fig. 18 is a view similar to Fig. 14 showing a contact element in the other row being engaged by the seating roller.

Fig. 19 is a view similar to Fig. 15 showing an end view of a staking roller.

Fig. 20 is a view similar to Fig. 16 showing a contact element in the other row being staked by a staking roller.

Fig. 21 is a view similar to Fig. 17 showing an end view of the severing wheels for the other row of contacts

Dimensions of certain parts as shown in the drawings may have been modified or exaggerated for the purpose of illustration.

- 7 -

## Description of the Preferred Embodiment

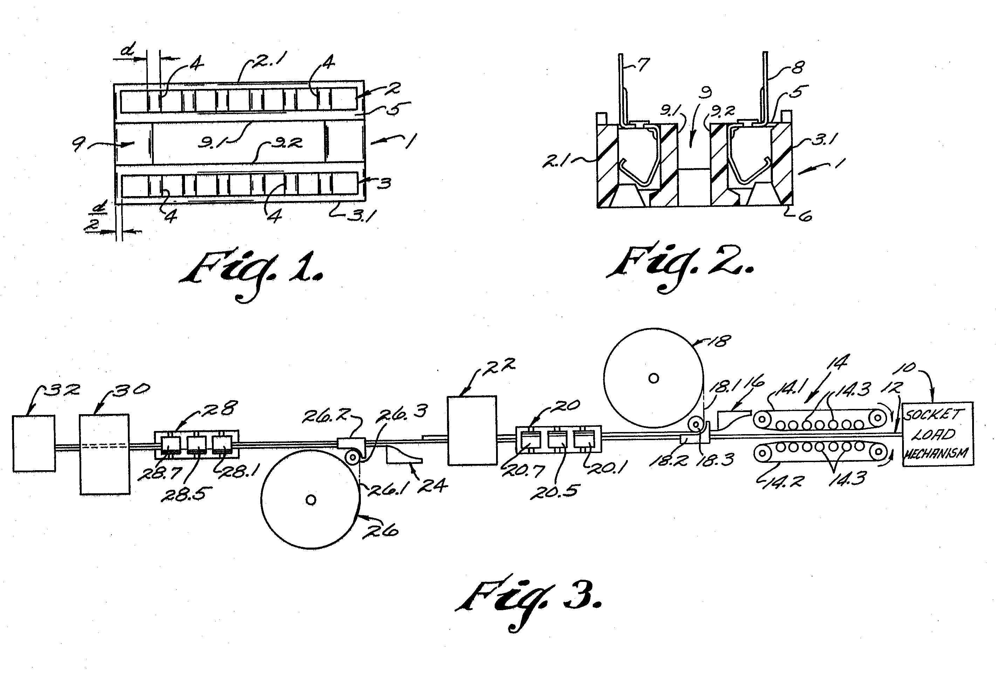

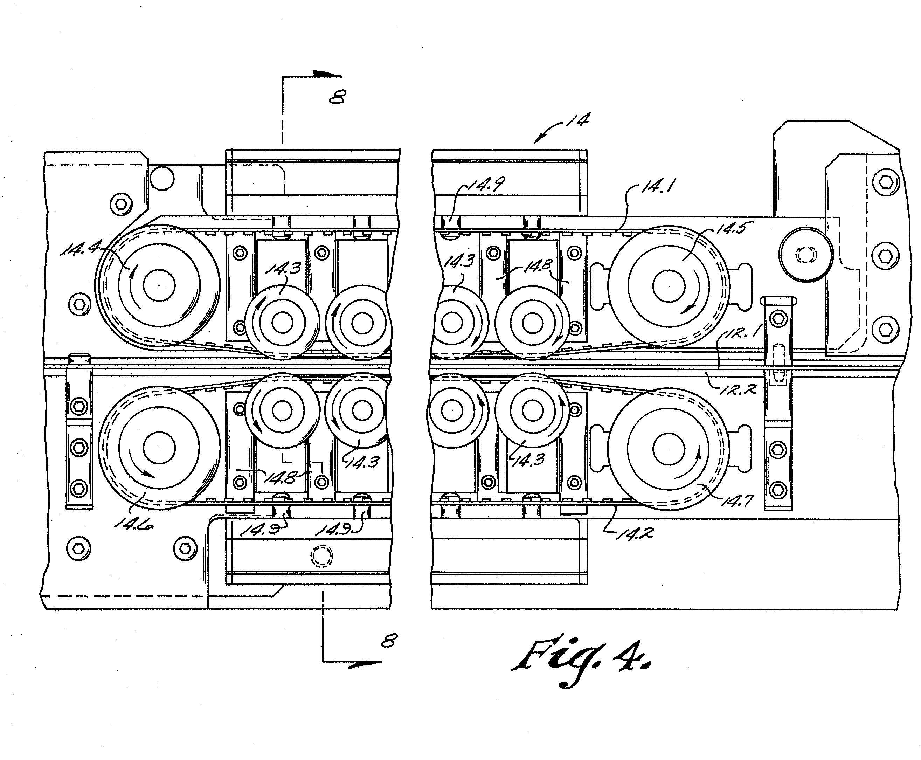

Referring now to the drawings, a typical socket
body into which contact elements are to be assembled in
accordance with the invention is shown in Fig. 1,
indicated by the numeral 1, comprising first and second
parallely extending rows 2 and 3 of contact receiving
apertures 4 extending from the top surface 5 to the
bottom surface 6. Fig. 2 shows contact elements 7 and 8
received in respective contact receiving apertures after
they have been assembled into the socket body. Further
details of a suitable integrated socket, which is amenable
to being assembled in accordance with the inventionn is
described and claimed in copending and coassigned U.S.
application Serial No. 300,077 filed September 8, 1981
however it will be realized that the invention is useful
in assembling many types of elements receivable in element
receiving apertures of a body.

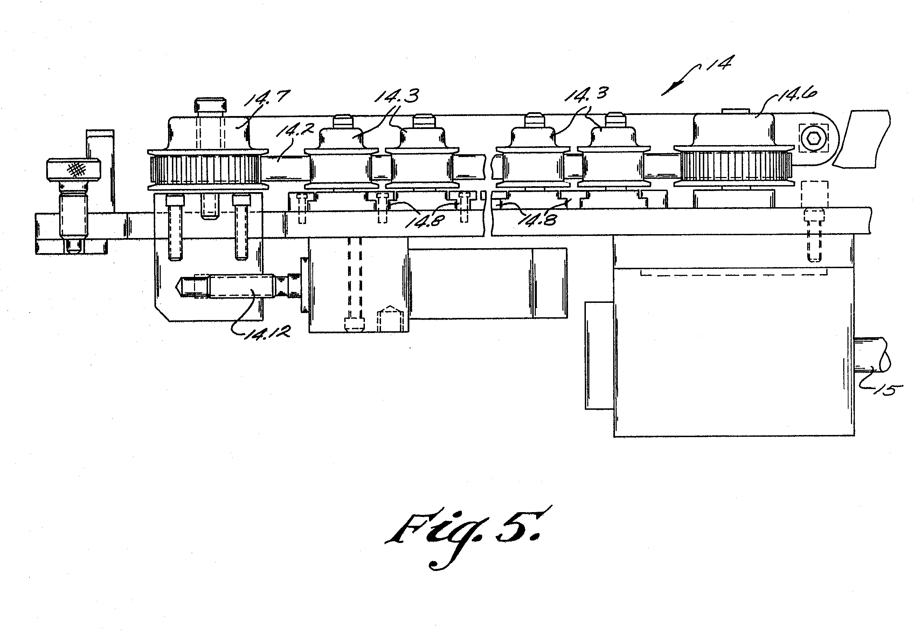

Fig. 3 schematically depicts the several stations
and paths involved in practicing the invention starting
with any suitable socket loading mechanism 10 adapted
to place a supply of socket bodies 1, one body after
another, lengthwise onto a track 12 and into a drive
station 14. Drive station 14 comprises opposed endless
belts 14.1 and 14.2 disposed on opposite sides of track
12 and adapted to frictionally engage opposed sides of
the bodies and move them along a first path through the
several stations of the apparatus. A series of idler
rolls 14.3 are movably mounted within the area circumscribed
by each belt 14.1 and are biased  against the belt to impart a selected, force to the bodies disposed
therebetween. Since drive station 14, as will be further
described below, is the only drive provided for moving
the bodies and the contact elements through the apparatus,
it is desirable to firmly engage the bodies through the
movable walls of belts 14.1 and 14.2. Thus by using a
plurality of loaded idler rolls, a large total force can
be imparted while avoiding over-concentrating the force
on a short section of connector bodies with concomitant
chances of crushing the socket bodies. As depicted in
Fig. 3, a series of eight idler rollers for each drive
belt 14.1, 14.2 has been found to be suitable with a
load of approximately ten pounds placed on each roller.

After exiting the drive station 14 the bodies are
referenced to one side of the track by a cam 16 so that
one of the rows 2 and 3 is a predetermined distance
from that side of the track. With reference again to
Fig. 1 it should be pointed out that the distance that
row 2 of apertures 4 from side 2.1 of body 1 is identical
to the distance that row 3 of apertures 4 from side 3.1
and that the spacing between adjacent apertures in a row is
uniform and equal to "d" while the spacing between the
first and last aperture in a row to the closest end of
the body is one half "d".

After the bodies are cammed to one side of the track
12, a continous carrier strip having elongated contact
elements depending therefrom is directed from a suitable

- 9 -

supply, such as a large reel 18, along a suitable second
path 18.1 into a guide rail means 18.2 with the first and
second paths adapted to converge and meet one another
tangentially with the contact elements received sequentially
in the contact receiving aperture of the row closest
to the referenced side of the body, e.g. row 2 shown in
Fig. 1. As will be described in further detail infra,
at least one of the first and second paths is formed with a
curved portion to accommodate reception of the contact
elements into the contact element receiving apertures.

Motion from the bodies is transferred to the carrier
web through the contact elements once they are received
in their respective apertures so that the carrier strip
is pulled out of the reel as needed, assuring proper
alignment of the contact elements, which are spaced a
distance "d" from one another on the carrier, with
respective contact element receiving apertures. After
the contact elements are received in their respective
apertures, the bodies are passed through a seating and
staking station 20. The contact elements are engaged
by a seating surface in the form of a roll, however other
surfaces could be employed if so desired, in order to
insure that the elements are fully seated in their apertures.
This is followed by deforming a selected portion of the
body onto the seated contact element to securely maintain
the contact elements in their seats. As shown in the
figures, two staking rollers are employed for this purpose
to incrementally deform a protrusion onto a transversely extending portion of the contact element however it will be realized that other deforming means could be used such as an ultrasonic head or a heated rail surface.

Following the seating and staking station the bodies are received at severing station 22 where the contact elements are severed from the carrier strip.

The bodies, freed from the carrier strip but still driven by upstream bodies, are referenced to the other side of the track by cam 24 so that side 3.1 of body 1 and hence row 3 is at the same predetermined distance from that side of the track as was row 2 when it received its contact elements as described above.

A second continous carrier strip with depending contact elements is supplied from a suitable reel 26 and directed along a third path into a guide rail means 26.2 with the first and third paths adapted to converge and meet one another tangentially with the contacts received sequentially in the contact receiving apertures of the row closest to the referenced side of the body, e.g. row 3 shown in Fig. 1. As in the case of the first and second paths, at least one of the first and third paths is formed with a curved portion to accommodate reception of the contact elements into the contact element receiving apertures.

It should be noted that in inserting the contact elements in row 2 body side 2.1 is used as a reference surface while side 3.1 is used as a reference surface for inserting the contact elements in row 3 independently of the particular distance between the two rows. Thus
any body width, within a minimum and maximum design limit,
can be accommodated in practicing the invention without
making any adjustments to the apparatus.

After the contact elements are received in their
respective apertures, the bodies are passed through a
sealing and staking station 28 similar to station 20
for row 2 of apertures, and then are passed through
severing station 30 where the contact elements of row 3
are severed from the carrier strip thereby completing
the assembly of the electrical socket. The sockets are
finally received in a suitable storage or shipping means
32 for eventual use.

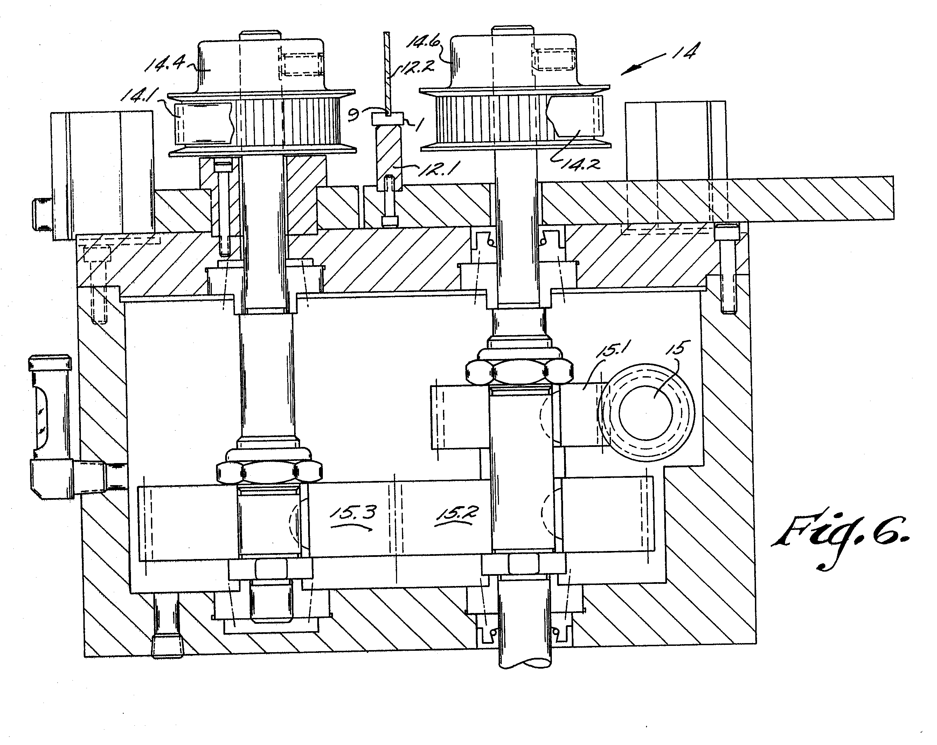

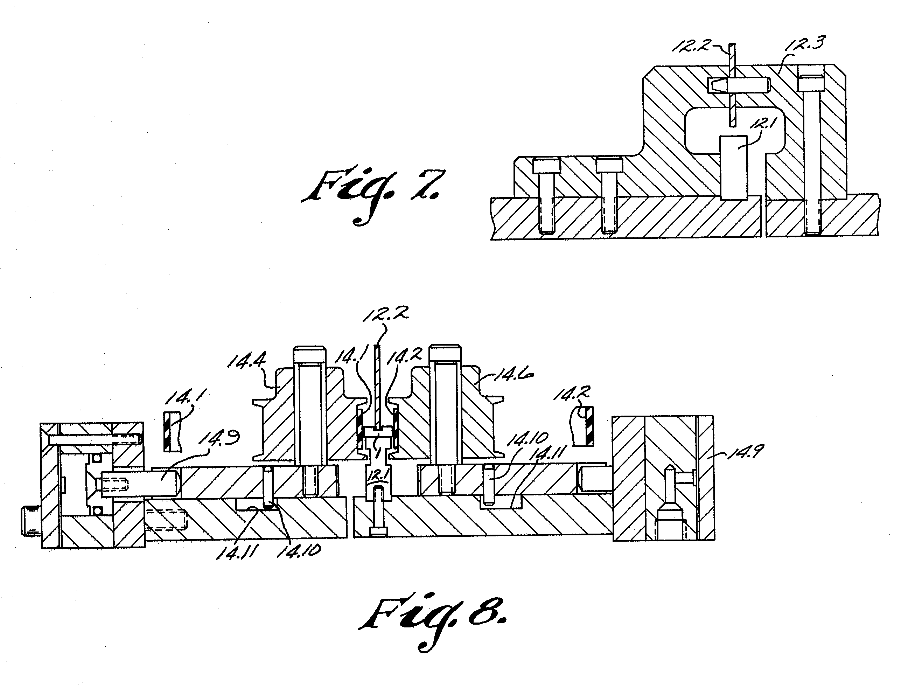

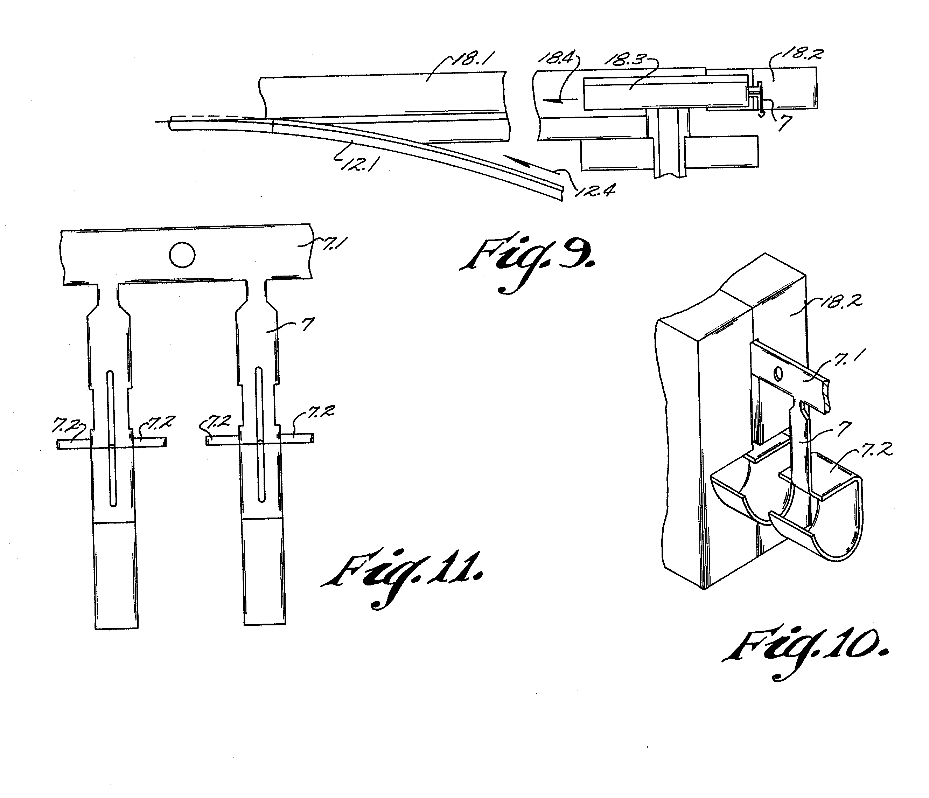

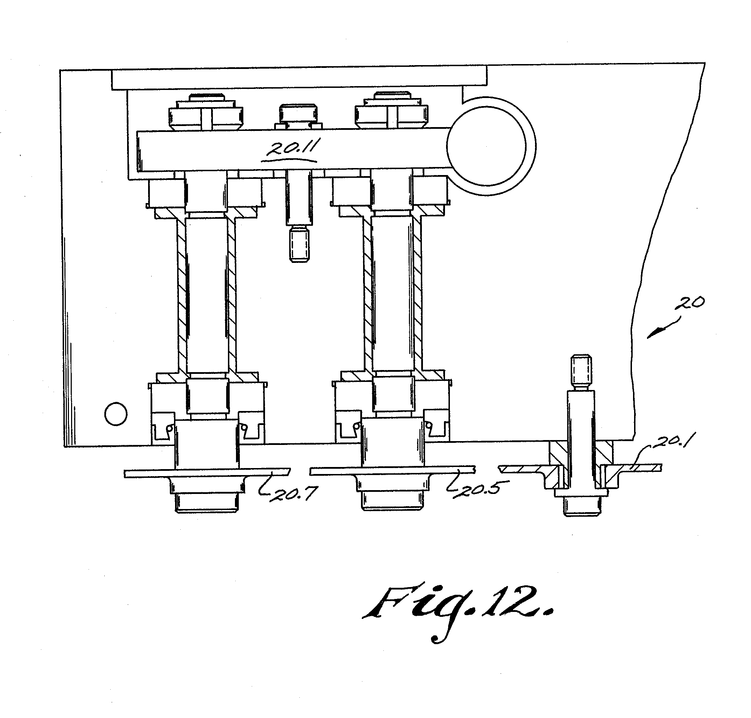

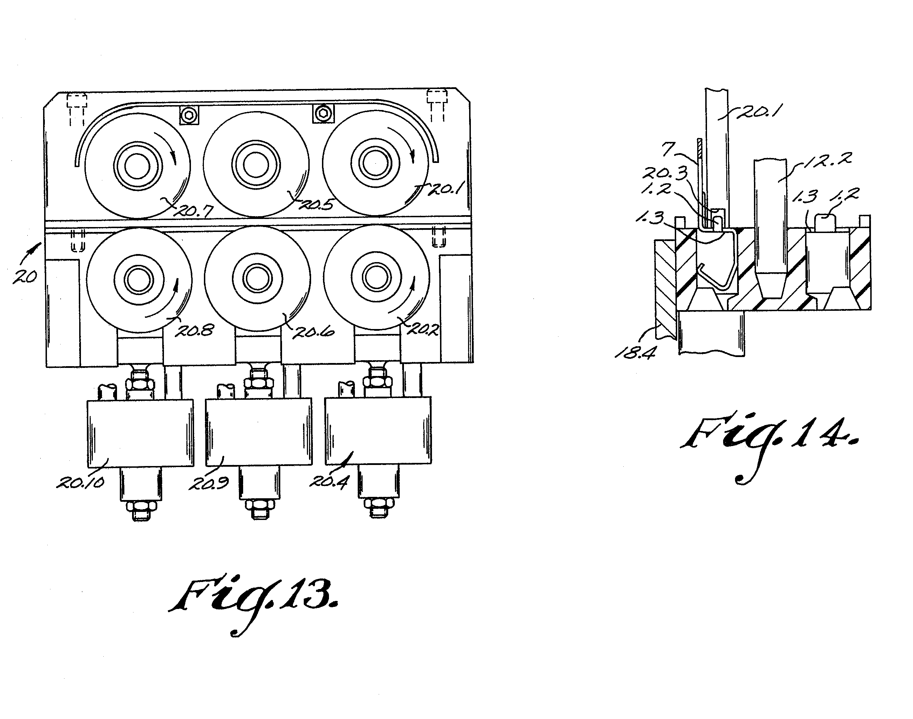

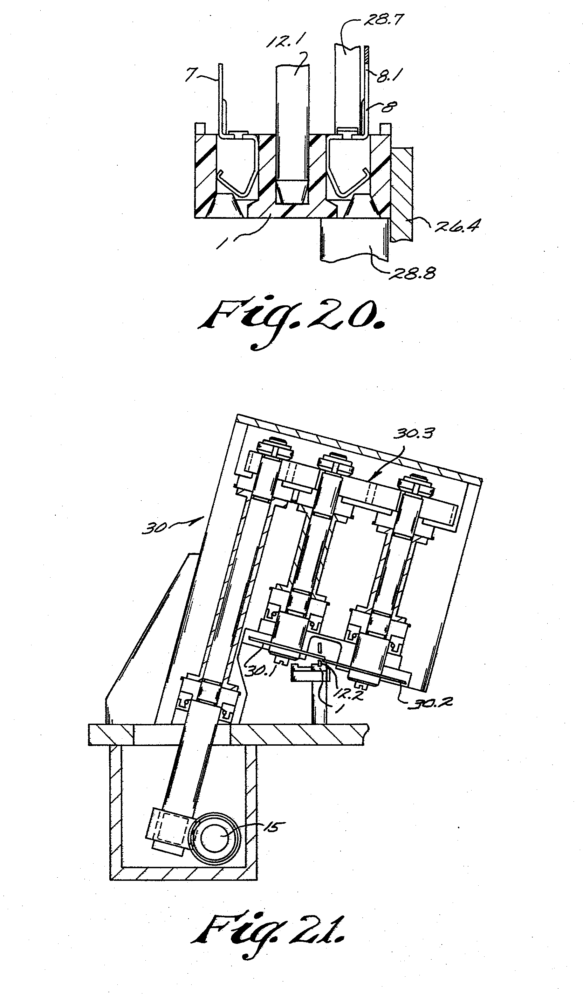

With particular reference to Figs. 4-8 the driving
station will be described in greater detail. Belts 14.1
and 14.2 are trained between sheaves 14.4, 14.5 and 14.6,
14.7 respectively. The sheaves and belts are preferably
timing sheaves and belts so that the driving sheaves 14.4,
14.6 can be geared together to drive belts 14.1 and 14.2
at indentical speeds. As best seen in Fig. 6, a main
drive shaft 15 drives sheave 14.6 through gear 15.1
which drive in turn is transferred to sheave 14.4 through
gears 15.2 and 15.3 respectively. Also seen in Fig. 6 is
an end view of a socket 1 disposed on track portion 12.1
with a rib 12.2 received in a lengthwise extending groove
9 in the socket (see also Fig. 1 for an enlarged view of
groove 9). Track portion 12.1 and rib 12.2 are disposed
intermediate belts 14.1, 14.2 and are adpated to permit socket bodies to slide therebetween with belts 14.1,
14.2 adapted to be biased against sides 2.1, 3.1 of
bodies 1 through loaded idler rolls 14.3. Idler rolls
14.3, although shown as having smooth circumferential
surfaces, may if desired, be provided with grooves to
receive the timing belt ribs. Idler rolls 14.3 are
each mounted in a transversely extending track mechanism
14.8 and are adpated to be urged toward track portion
12.1 and rib 12.2 by pneumatic means between minimum
and maximum limits determined by a peg 14.10 received
in a stop surface groove 14.11 (Fig. 8). It will be
understood that if preferred, a spring arrangement could
be employed to load idler rolls 14.3 however pneumatic
means are preferred since even distribution of the load
among the several rolls is more easily achieved. As
best seen in Fig. 5, which shows the drive station 14 in
the reverse orientation to that of Fig. 3, that is,
drive sheave 14.7 is shown at the right in Fig. 14, the
spacing between a pair of sheaves can be adjusted via
adjustment mechanism 14.12 which can move the mount of
idler sheave 14.7 to the right or left as desired.

Figure 7 shows a support bracket 12.3 for maintaining
rib 12.2 in a selected spaced position relation to track
portion 12.1 to permit bodies to slide therebetween.

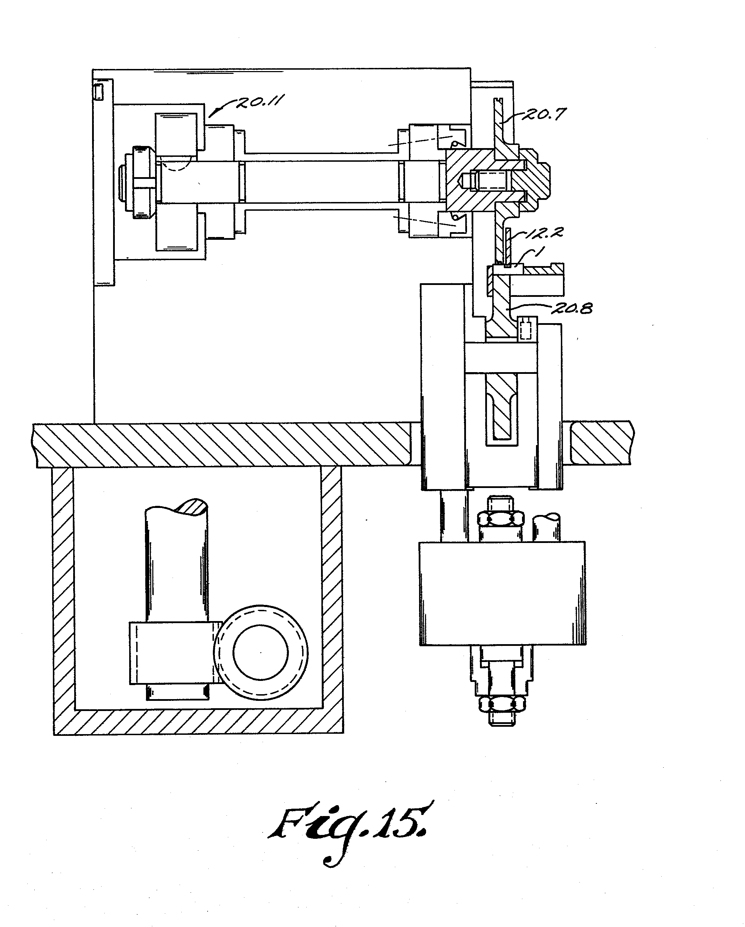

With reference to Fig. 9 the carrier strip from which depend contact elements 7 is shown entering a guide rail means 18.2 after being trained around a small guide wheel 18.3 from reel 18 so that the strip directed along path 18.1. A portion of body track 12.1 is curved relative to path 18.1 so that they converge with contact elements moving in the direction of arrow 18.4 and socket bodies moving up track 12.1 in the direction of arrow 12.4 until the bottom extreme portions of the contact elements are received in a receiving aperture 4 of body 1. Further movement results in the contact element moving further into its respective aperture.

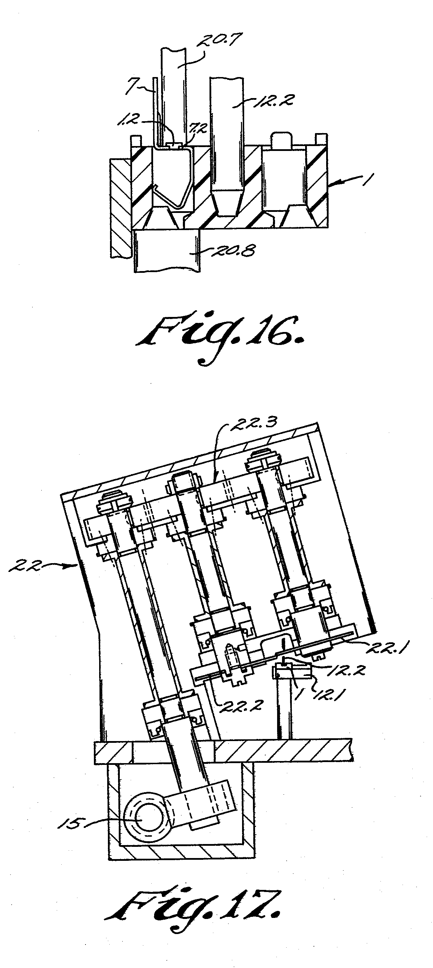

The guide track for carrier strip 7.1 may totally enclose contact elements as seen in Fig. 10 or partially enclose them as indicated in Fig. 9 as desired.

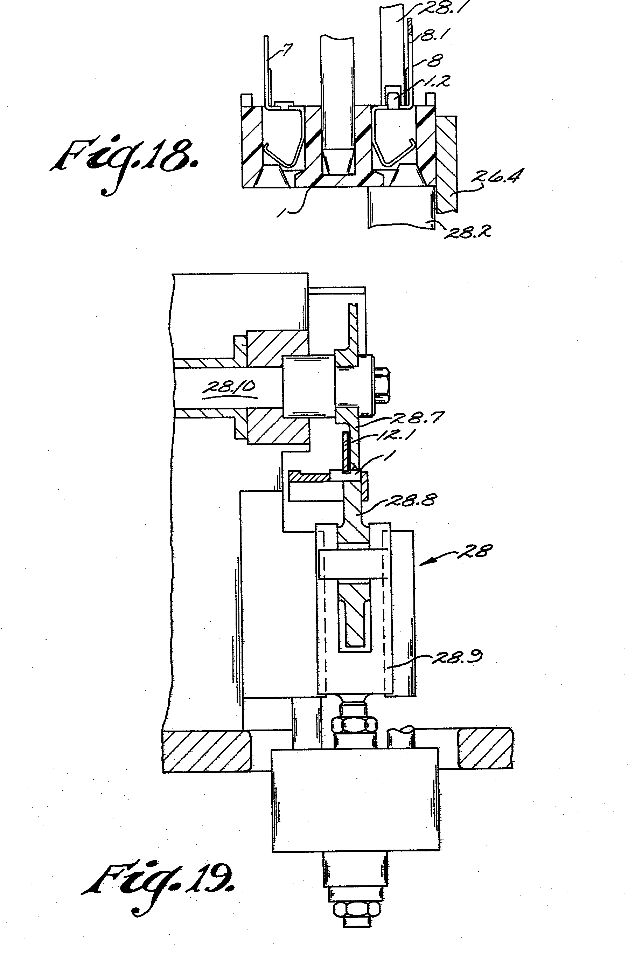

With particular reference to Figs. 13 to 15, once the socket bodies have the contact elements received in their respective apertures, the bodies are received at the seating and staking station 20. The bodies first pass between a pair of seating rolls, upper roll 20.1 and lower roll 20.2, preferably non-driven with bottom roll 20.2 urged by conventional pneumatic means 20.4 toward the upper roll 20.1 with a bottom roll 20.2 urged by conventional pneumatic means 20.4 toward the upper roll 20.1 with a selected force. As best seen in Fig. 14, socket body 1 is provided with tower portions or projections 1.2 extending above the top surface of the socket body. Projections 1.2 are provided between each of the apertures in a row as well as at the beginning and end of each row. The upper surface of the socket body has a transversely extending surface 1.3 which acts as a seat for transversely extending surface portions 7.2 of the contact element. The profile of the circumferential surface of upper roll 20.1 is configured in order to engage contact element portion 7.2 and ensure that it bottoms out on surface 1.3 of the socket body while a cut out portion 20.3 in the peripheral surface of the roll 20.1 avoids engagement with the projections 1.2 of socket 1.

After ensuring that the contact elements are fully seated, the bodies pass between two pairs of staking rolls. The particular number of pairs used is a matter of choice depending upon the degree of deformation desired at each pair of rollers. Further, as mentioned supra, deforming surfaces other than rolls could be employed if so desired. As shown in station 20, a first pair of rolls, upper roll 20.5 and lower roll 20.6 is follwed by a second pair of rolls, upper roll 20.7 and lower roll 20.8. The lower rolls are urged toward the upper rolls by suitable means such as pneumatic means 20.9 and 20.10 respectively. The profile of upper rolls 20.5 and 20.7 is such that the roll surface engages the projections 1.2 deforming them onto contact portion 7.2 to securely fasten the contact elements to the socket body. Thus the annular recess formed in roll 20.5 will be more than that formed in roll 20.7 so that roll 20.5 partially deforms the projection while roll 20.7 completes the deformation as best seen in Fig. 16. For optimum deformation of projections 1.2 it is preferred to drive rolls 20.5 and 20.7 by drive 20.11 so that the surface of the rolls contacting projections 1.2 move at approximately the same speed as the socket bodies so that the deforming force will essentially be in a downward direction.

Following the seating and staking station the socket bodies pass through severing station 22 seen in Fig. 17. Severing station 22 comprises first and second counter rotating severing wheels or discs 22.1, 22.2 adapted to sever contacts 7 from carrier strip 7.1 as the contacts are passed therebetween. The longitudinal axes of wheels 22.1 and 22.2 lie in a plane which is perpendicular to the path of the sockets and the axes are parallel to each other and inclined toward the plane in which the contact elements move so that positive clearance is provided between the cutting wheel and the contact element once the cut is completed. The wheels are driven through gearing 22.3 from main drive 15.

- 15 -

The bodies 1, after leaving station 22, are no
longer connected to carrier strip 7.1 however they are
still driven by drive unit 14 through upstream bodies.
The bodies contact cam 24 (Fig. 3) and are referenced
to the other side of track 12.2.

Another carrier strip having depending contacts 8
is directed from a suitable supply such as reel 26,
along a third path 26.1, around a guide wheel 26.3
into a guide track 26.2, similar to guide track 18.2 but
aligned with the opposite side of the track. Again, as
shown in Fig. 9, socket body track 12.1 is curved over
a portion of its length and is adapted to converge with
the third path 26.1 with the contact elements adapted
to be received in contact receiving apertures of row 3
(Fig. 1).

Following reception in the receiving apertures the
contact elements pass through seating and staking station
28 where the complete seating of the contact elements is
ensured by idler seating roll 28.1 cooperating with roll
28.2 urged against the bottom of the socket body (Fig. 18).
Following this step the socket bodies pass through staking
roll pairs, top roll 28.5, bottom roll 28.6 (not shown)
and top roll 28.7, bottom roll 28.8. Fig. 19 shows
staking roll 28.7 in contact with a body with opposed
bottom roll 28.8 biased against the bottom surface of
body 1 by suitable means such as pneumatic means 28.9.

- 16 -

Top roll 28.7 is driven as in the case of rolls 20.5 and 20.7, through shaft 28.10, ultimately connected through suitable steering to drive shaft 15.

After the contact elements are staked to bodies 1 the bodies are passed through severing station 30 seen in Fig. 21. Severing station 30, similarly to severing station 22, comprises first and second counter rotating severing wheels or discs 30.1, 30.2 adapted to sever contacts 8 from carrier strip 8.1 as the contact elements are passed therebetween. The longitudinal axes of wheels 30.1 and 30.2 lie in a plane which is perpendicular to the path of the sockets and the axes are parallel to each other and inclined toward the plane in which the contact elements move but in the opposite sense from that of station 22 so that positive clearance is provided between the cutting wheel and the contact element once the cut is completed as well as clearing the upper extremities of contact elements 7 of the first row.

After being severed from carrier strip 8.1 the sockets are completely assembled and are pushed onto a suitable packaging or storage mechanism 32.

- 17 -

0122058

By means of the above described method and apparatus, sockets can be assembled at a greatly increased rate compared to prior art systems. For example, apparatus made in accordance with the invention is capable of assembling sockets at a rate easily exceeding 1200 inches per minute which is equivalent to approximately 1500 sixteen position sockets as opposed to a rate of 300 sixteen pin sockets per minute or so for prior art equipment. No set time is required to prepare the apparatus for various length or width sockets. Rib 12.1 received in groove 9 of socket body 1 contacts surface 9.1 (Fig. 2) regardless of the width of groove 9 and references body against surface 18.4 (Fig. 14) for the first row of apertures and then after the sockets are cammed to the other side of the track for row 3 rib 12.1 contacts surface 9.2 and references body 1 against surface 26.4 (Figs. 18, 20).

It will be noted that while track 12.1 has been shown to include a curved portion so that the first and second paths and the first and third paths merge tangentially, the paths of the socket bodies could be straight with the contact element paths curved, or all three paths could include a curved portion and still achieve the same result. The particular radius for the curved portion is chosen to provide apparatus which is not unduly long yet which provides sufficient clearance to provide convenient access to the component parts of the apparatus for servicing.

- 18 -

Operation of the apparatus is initiated by driving the socket bodies via drive station 14 until the bodies approach guide rail means 18.2 where the carrier strip is fed by hand until contact elements are received in receiving apertures after which driving force from drive station 14 is transferred to the carrier strips via the contact elements which pull the carrier strip from reel 18 as required.  The sockets are then processed continously until the first bodies approach guide rail means 26.2 at which point the second carrier strip is fed by hand until contact elements are received in the apertures of the second cam so that body motion can be transferred to carrier strip 8.1 from reel 26 pulling the carrier strip as needed.

The pushing drive of the driving station assures that no gaps occur between consecutive socket bodies so that alignment of the apertures of a body with the contact elements depending from a carrier strip is inherent.

While the invention has been shown and described with reference to particular embodiments thereof, it will be understood by those skilled in the art that the foregoing and other changes in form and detail may be made without departing from the spirit and scope of the invention.

CLAIMS:

1. Apparatus for assembling electrically conductive, elongated elements in an electrically insulative body having element receiving apertures therein comprising

a track forming a first path,

spaced movable walls disposed on opposite sides of at least a portion of the track, the movable walls being biased toward one another between a minimum and a maximum distance,

means for feeding a plurality of bodies onto the track between the spaced walls, the bodies having a width between the minimum and the maximum distance and having a plurality of element receiving apertures forming seats for the elongated elements,

means for moving the movable walls to impart motion to the bodies, moving them along the track,

means for directing a freely movable, continuous carrier strip having a plurality of elongated elements depending therefrom along a second path, which meets tangentially with the first path, the elongated elements received in the element receiving apertures of a body as the body is moved along the first path where the first and second path converge,

means to stake the elongated elements to the bodies after they are seated, and

means to sever the elongated elements from the carrier strip.

2. Apparatus according to claim 1 in which the moving walls comprise a pair of endless belts.

3. Apparatus according to claim 2 in which a plurality of idler rolls are placed within each belt, the idler drive rolls being mounted to move toward and away from the track between first and second limits, and means to urge the rolls toward the track.

4. Apparatus according to claim 1 in which the track includes an elongated rib and the bodies are provided with a longitudinally extending rib receiving slot.

5. Apparatus according to claim 1 in which the means to stake the elongated elements to the bodies comprise a pair of rolls disposed above and below the first path, the bodies provided with a transversely extending surface adjacent the element receiving apertures and a projection extending above the transversely extending surface between adjacent apertures in each body, the elongated elements having an offset section which extends in a transverse direction, one of the rolls adapted to engage the projections as the body moves passed the rolls and deform the projections onto a portion of the transversely extending section of the elongated element to securely lock the element to the body.

6. Apparatus according to claim 1 in which the bodies have a longitudinal axis and front and back ends, the bodies are provided with at least two longitudinally extending rows of elongated element receiving apertures, each aperture in a row spaced a distance d from its closest adjacent aperture in the row, the first and last apertures in a row respectively spaced 1/2 d from the front and back end of the body.

7. Apparatus according to claim 6 in which the bodies have opposite side walls and a groove extending longitudinally from the first end to the back end and the track has a rib receivable in the groove, reference side wall means disposed on a side of the first path, and means to place the bodies on the track so that the rib is received in the groove with one side wall of each body is in contact with said reference side wall and the elongated elements are inserted into the row of apertures closest to the said one side wall.

8. Apparatus according to claim 7 further including a second reference side wall means disposed on another side of the first path and camming means disposed downstream of the staking means adapted to move the bodies laterally on the track so that another side wall of each body is in contact with the second reference side wall with the rib still maintained in the groove,

means for directing a second, freely movable continuous carrier strip having a plurality of elongated elements depending therefrom along a third path which meets tangentially with the first path, the elongated elements received in the element receiving apertures of the other row as the body is moved along the first path where the first and third paths meet,

means to ensure that the elongated elements are fully seated in respective apertures of the other row

means to stake the elongated elements to the bodies after they are seated, and

means to sever the elongated elements from the second carrier strip.

9 .  A method for assembling a plurality of
electrically conductive elongated elements in an electrically
insulative body having element receiving apertures therein
comprising the steps of

forming a track along a first path,

disposing spaced, movable surfaces on
opposite sides of at least a
portion of the path,

feeding a plurality of bodies sequentially
onto the track between the movable
surfaces,

biasing the movable surfaces against
opposite sides of the bodies,

moving the movable surfaces so as to impart
movement of the bodies along the track

directing a continuous carrier strip having
a plurality of elongated elements
depending therefrom along a second path
which meets tangentially with the first
path, the elongated elements received in
the element receiving apertures of the
body as the first and second paths meet,

biasing the elongated elements disposed in
the element receiving apertures so that
they are fully seated in the aperture,

staking the body contiguous to each elongated
element to secure said element to the body
and

severing the elongated elements from the
carrier strip,

motion being transferred to the carrier strip
from the movable surfaces through the
bodies and elongated elements assembled
therein prior to severing of the elongated
elements from the carrier strip.

10. Apparatus for assembling electrically conductive elements in an electrically insulative body having elements receiving apertures therein comprising

means to move a plurality of bodies along a first path one behind another in abutting relation one with another,

means for directing a movable, continuous carrier strip having a plurality of electrically conductive elements depending therefrom along a second path,

one of the first and second paths including a curved segment adapted to meet the other of the first and second paths tangentially with the depending elements being received in the element receiving apertures of the body as the body is moved along the first path where the first and second paths meet, and

means to separate the elements from the carrier strip.

Fig. 1.

Fig. 2.

Fig. 3.

Fig. 4.

Fig. 5.

Fig. 6.

Fig. 7.

Fig. 8.

18.1

18.4  18.3  18.2

7

12.1

12.4

*Fig. 9.*

7.1

7

7.2  7.2  7.2  7.2

*Fig. 11.*

18.2

7.1

7

7.2

*Fig. 10.*

0122058

*Fig. 12.*

20.11

20

20.1

20.5

20.7

0122058

**Fig. 13.**

20.7  20.5  20.1
20  
20.8  20.6  20.2
20.10  20.9  20.4

**Fig. 14.**

20.1  7  20.3  1.2  1.3  12.2  1.3  1.2  18.4

Fig.15.

Fig.16.

Fig.17.

**Fig.18.**

28.1
8.1
7
8
1.2

26.4

1

28.2

28.10

28.7
12.1
1

28.8

28

28.9

**Fig.19.**

Fig. 20.

Fig. 21.